# EUROPÄISCHE PATENTSCHRIFT

(11) **EP 2 337 101 B1**
(45) Veröffentlichungstag und Bekanntmachung des Hinweises auf die Patenterteilung: **27.11.2019**
(21) Anmeldenummer: 10187350.3
(22) Anmeldetag: 13.10.2010
(51) Int. Cl.: H01L 35/32, F01N 5/02

(54) **Abgasanlage mit thermoelektrischem Generator**
Exhaust system with thermoelectric generator
Système d'échappement avec un générateur thermoélectrique

(30) Priorität: 17.12.2009 DE 102009058948
(43) Veröffentlichungstag der Anmeldung: 22.06.2011
(73) Patentinhaber: Eberspächer Exhaust Technology GmbH & Co. KG, 66539 Neunkirchen (DE)
(72) Erfinder: Oesterle, Jörg, 89150, Laichingen (DE); Jebasinski, Rolf, 70794, Filderstadt (DE); Nording, Thomas, 73734, Esslingen (DE); Wirth, Georg, 73230, Kirchheim/Teck (DE)
(74) Vertreter: BRP Renaud & Partner mbB Rechtsanwälte Patentanwälte Steuerberater

(56) Entgegenhaltungen:
- EP-A1- 1 780 807
- WO-A1-2007/133069
- DE-A1-102006 039 024
- US-A- 6 096 966

## Beschreibung

Die vorliegende Erfindung betrifft eine Abgasanlage für eine Brennkraftmaschine, insbesondere eines Straßenfahrzeugs oder einer sonstigen mobilen oder stationären Einrichtung, mit den Merkmalen des Oberbegriffs des Anspruchs 1. Des Weiteren betrifft die Erfindung ein Verfahren zum Herstellen einer derartigen Abgasanlage.

Abgasanlagen sind allgemein bekannt und dienen bei Brennkraftmaschinen zum Abführen von Verbrennungsabgasen. Eine solche Abgasanlage umfasst eine Vielzahl unterschiedlicher Bauteile, wie zum Beispiele Rohre und Abgasbehandlungseinrichtungen. Die einzelnen Bauteile sind miteinander verbunden und bilden einen Abgasstrang, in dem die einzelnen Abgasbehandlungseinrichtungen über Rohre miteinander verbunden sind. Abgasbehandlungseinrichtungen sind beispielsweise Oxidationskatalysatoren, Partikelfilter, SCR-Katalysatoren und NOX-Speicherkatalysatoren.

Aus der DE 10 2006 039 024 A1 ist eine Abgasanlage bekannt, die ein abgasführendes Bauteil aufweist, das eine in Umfangsrichtung ringförmig geschlossene Innenwand aufweist, deren Innenseite dem Abgas ausgesetzt ist, wobei die Abgasanlage außerdem wenigstens einen thermoelektrischen Generator aufweist, der Wärme in elektrische Energie wandelt und der an einer Außenseite der Innenwand des Bauteils angeordnet ist. Des Weiteren ist bei der bekannten Abgasanlage ein Kühlmantel vorgesehen, der den thermoelektrischen Generator in der Umfangsrichtung umschließt, wobei der thermoelektrische Generator innen eine thermisch leitende, elektrisch isolierende innere Barriereschicht und außen eine thermisch leitende, elektrisch isolierende äußere Barriereschicht aufweist, über die der thermoelektrische Generator an der Außenseite der Innenwand des Bauteils und an einer Innenseite einer Innenwand des Kühlmantels unmittelbar abgestützt ist.

Eine gattungsgemäße Abgasanlage ist aus der WO 2007/133069 A1 bekannt, bei der eine Federstruktur vorgesehen ist, über die der thermoelektrische Generator unter Vorspannung an einem Kühlmantel abgestützt ist, der den thermoelektrischen Generator ringförmig geschlossen umfasst, der seinerseits die Innenwand des Bauteils ringförmig geschlossen umfasst. Bei der bekannten Abgasanlage ist die Federstruktur durch eine Spiralfeder gebildet, die koaxial zum Kühlmantel und koaxial zum thermoelektrischen Generator angeordnet ist.

Die vorliegende Erfindung beschäftigt sich mit dem Problem, für eine Abgasanlage eine verbesserte Ausführungsform anzugeben, die sich insbesondere dadurch auszeichnet, dass sie eine verbesserte Energierückgewinnung ermöglicht, wodurch insbesondere der energetische Wirkungsgrad der mit der Abgasanlage ausgestatteten Brennkraftmaschine bzw. eines mit der Brennkraftmaschine und der Abgasanlage ausgestatteten Fahrzeugs erhöht werden soll.

Dieses Problem wird erfindungsgemäß durch die Gegenstände der unabhängigen Ansprüche gelöst. Vorteilhafte Ausführungsformen sind Gegenstand der abhängigen Ansprüche.

Die Erfindung beruht auf dem allgemeinen Gedanken, die im Abgas enthaltene Wärme in elektrische Energie zu wandeln. Hierzu schlägt die Erfindung vor, zumindest ein Bauteil der Abgasanlage, das eine im Betrieb der Brennkraftmaschine Abgas führende Innenwand besitzt, mit einem thermoelektrischen Generator zu koppeln, der Wärme in elektrische Energie wandelt. Hierdurch kann die im Abgas enthaltene Abwärme direkt zum Erzeugen elektrischer Energie genutzt werden, die der Brennkraftmaschine bzw. dem damit ausgestatteten Fahrzeug zur Verfügung gestellt werden kann. Insoweit kann der energetische Wirkungsgrad des Fahrzeugs verbessert werden.

Thermoelektrische Generatoren arbeiten beispielsweise nach dem Prinzip eines Peltier-Elements, jedoch in einem inversen Betriebsmodus. Während ein Peltier-Element durch Anlegen einer Spannung Wärme von einer Kaltseite zu einer Warmseite des Peltier-Elements transportiert, wird bei einem thermoelektrischen Generator bzw. bei einem einzelnen thermoelektrischen Element dieses Prinzip dahingehend umgekehrt, dass eine elektrische Spannung, die dadurch entsteht, dass Wärme von einer Warmseite zu einer Kaltseite des thermoelektrischen Elements fließt, abgegriffen wird. Mit Hilfe eines derartigen thermoelektrischen Elements kann somit Wärmefluss in elektrische Energie gewandelt werden.

Konkret schlägt die Erfindung vor, den thermoelektrischen Generator an einer Außenseite der Innenwand des Bauteils anzuordnen, deren Innenseite dem Abgas ausgesetzt ist. Somit trennt die Innenwand den thermoelektrischen Generator vom Abgas und schützt ihn insbesondere vor einer Verschmutzung durch das Abgas. Die Innenwand ist dabei in Umfangsrichtung geschlossen und kann ein Rohr sein oder einen rohrförmigen Abschnitt des jeweiligen Bauteils bilden. Die Umfangsrichtung ist dabei mit Bezug auf die Strömungsrichtung des Abgases im Bauteil bzw. auf die Hauptströmungsrichtung des Abgases im Bauteil bezogen, derart, dass besagte Strömungsrichtung oder Hauptströmungsrichtung eine Axialrichtung definiert, bezüglich der die Umfangsrichtung umläuft.

Gemäß einer vorteilhaften Ausführungsform kann der thermoelektrische Generator die Innenwand in Umfangsrichtung ringförmig geschlossen umfassen. Somit umschließt der thermoelektrische Generator die Innenwand, was eine gleichmäßige Wärmeabgabe von der Innenwand an den thermoelektrischen Generator ermöglicht. Gleichzeitig kann die Effektivität der Wärmenutzung verbessert werden.

Gemäß einer anderen vorteilhaften Ausführungsform kann das Bauteil eine Außenwand aufweisen, welche die Innenwand des Bauteils in Umfangsrichtung ringförmig geschlossen umfasst. Der thermoelektrische Generator ist dann zwischen der Innenwand und der Außenwand angeordnet. Hierdurch wird der thermoelektrische Generator zwischen den beiden Wänden gekapselt, wodurch er einerseits durch die Innenwand vor dem Abgas und andererseits durch die Außenwand vor der Umgebung der Abgasanlage geschützt ist, was die Betriebssicherheit des thermoelektrischen Generators verbessert.

Bei einer anderen vorteilhaften Ausführungsform kann ein Kühlmantel vorgesehen sein, der die Innenwand in Umfangsrichtung ringförmig geschlossen umfasst, wobei dann der thermoelektrische Generator zwischen der Innenwand und dem Kühlmantel angeordnet ist. Der Kühlmantel ermöglicht eine gezielte Temperaturabsenkung außen am thermoelektrischen Generator. Hierdurch wird zum einen das Temperaturgefälle von der Innenseite des thermoelektrischen Generators bis zur Außenseite des thermoelektrischen Generators vergrößert. Zum anderen kann über den Kühlmantel die über den thermoelektrischen Generator von innen nach außen transportierte Wärme rasch abgeführt werden, um die hohe Temperaturdifferenz beizubehalten. Hierdurch kann die Umwandlung der Wärme in elektrische Energie verbessert werden.

Der Kühlmantel kann im einfachsten Fall durch ein doppelwandiges Rohr mit ringförmigem Kanalquerschnitt gebildet sein. Ebenso kann der Kühlmantel durch ein Kühlrohr gebildet sein, das sich schraubenförmig um den thermoelektrischen Generator erstreckt und dabei koaxial zur Innenwand ausgerichtet ist. Zweckmäßig kann die zuvor genannte Außenwand des Bauteils durch eine Innenwand des Kühlmantels gebildet sein, wodurch der Integrationsgrad der Abgasanlage im Bereich des thermoelektrischen Generators verbessert ist, was zu weniger Gewicht und reduzierten Herstellungskosten führt. Alternativ kann die Außenwand des Bauteils an einer Innenwand des Kühlmantels anliegen. Hierdurch wird eine separate Herstellung ermöglicht, die zu einer vereinfachten Montage führen kann.

Der thermoelektrische Generator kann entsprechend einer vorteilhaften Ausführungsform an der Außenseite der Innenwand unmittelbar anliegen, wobei jedoch insbesondere vorgesehen sein kann, dass der thermoelektrische Generator eine innere Kontaktschicht aufweist, mit welcher er an der Außenseite der Innenwand direkt anliegt. Die direkte Kontaktierung zwischen thermoelektrischem Generator und Innenwand verbessert die Wärmeübertragung zwischen Innenwand und thermoelektrischem Generator, was die Effektivität der Stromgewinnung verbessert.

Erfindungsgemäß ist der thermoelektrische Generator an einer Innenseite der Außenwand des Bauteils oder an einer Innenseite einer Innenwand des Kühlmantels über eine Federstruktur unter Vorspannung. Die Federstruktur enthält Bereiche mit unterschiedlicher Elastizität in Umfangsrichtung, wobei sich Bereiche höherer Elastizität und Bereiche niedrigerer Elastizität abwechseln.

Mit Hilfe dieser Federstruktur wird somit eine Vorspannung erzeugt, die den thermoelektrischen Generator einerseits gegen die Innenwand des Bauteils andrückt und die andererseits auch gegenüber der Außenwand des Bauteils bzw. der Innenwand des Kühlmantels eine vorgespannte Abstützung des thermoelektrischen Generators bewirkt. Darüber hinaus ermöglicht die Federstruktur Relativbewegungen des thermoelektrischen Generators bezüglich der Außenwand des Bauteils bzw. bezüglich der Innenwand des Kühlmantels. Dies ist vor allem dann von Vorteil, wenn sich bei einem Kaltstart der Brennkraftmaschine die Abgasanlage zunächst aufwärmt. Dabei wärmt sich die dem Abgas ausgesetzte Innenwand zuerst auf, wodurch sich diese nach außen ausdehnt. Hierdurch wird auch der thermoelektrische Generator nach außen bewegt und gegen die kältere Außenwand des Bauteils bzw. gegen die kältere Innenwand des Kühlmantels gedrückt. Dabei wird gleichzeitig die mit Hilfe der Federstruktur erzeugte Vorspannung vergrößert. Die Federstruktur ermöglicht somit einen Ausgleich thermisch bedingter Dehnungseffekte. Gleichzeitig erhöht sie die Vorspannung, mit welcher der thermoelektrische Generator die Wärmequelle (Innenwand) bzw. die Wärmesenke (Außenwand des Bauteils bzw. Innenwand des Kühlmantels) kontaktiert. Es hat sich gezeigt, dass die Qualität der Wärmeübertragung zunimmt, je höher die Vorspannung zwischen Wärmequelle und thermoelektrischem Generator einerseits und Wärmesenke und thermoelektrischem Generator andererseits ist. Die mit Hilfe der Federstruktur erzeugte Vorspannung führt somit zu einer erhöhten Effizienz der Energieumwandlung.

Besonders vorteilhaft ist eine Ausführungsform, bei welcher der thermoelektrische Generator modular aufgebaut ist, so dass er mehrere Generatormodule aufweist. Diese Generatormodule können einfach miteinander verschaltet werden, um den jeweiligen thermoelektrischen Generator einfach an unterschiedliche Einbausituationen anpassen zu können. Auch kann die Leistung des thermoelektrischen Generators durch die Anzahl der verwendeten Generatormodule bestimmt werden. Die einzelnen Generatormodule können in Umfangsrichtung benachbart angeordnet sein, so dass sie jeweils Umfangssegmente des thermoelektrischen Generators bilden. Ebenso ist es möglich, die Generatormodule so zu konfektionieren, dass sie in der Axialrichtung benachbart angeordnet sind. Folglich bilden die Generatormodule dann Axialabschnitte des thermoelektrischen Generators. Die Axialrichtung entspricht dabei der Strömungsrichtung bzw. Hauptströmungsrichtung des Abgases innerhalb der Innenwand des Bauteils. Ebenso ist es möglich, Generatormodule sowohl in der Umfangsrichtung als auch in der Axialrichtung zueinander benachbart anzuordnen, um den thermoelektrischen Generator aufzubauen. Die modulare Bauweise für den thermoelektrischen Generator vereinfacht auch die Anbringung des thermoelektrischen Generators an der Außenseite der Innenwand, was die Herstellung der Abgasanlage erleichtert.

Erfindungsgemäß kann eine derartige Abgasanlage dadurch hergestellt werden, dass die Außenwand, wenn der thermoelektrische Generator zwischen der Innenwand und der Außenwand angeordnet ist, mit dem Ziel einer definierten Querschnittsreduzierung plastisch verformt wird. Mit anderen Worten, das mit dem thermoelektrischen Generator ausgestattete Bauteil wird wie bei einem Canning-Prozess eines Katalysators oder eines Partikelfilters gezielt plastisch verformt. Die Verformung der Außenwand erfolgt dabei dahingehend, dass für den thermoelektrischen Generator eine gewünschte radiale Vorspannung erzeugt wird, die für den Wärmeübergang zwischen Innenwand und Generator einerseits sowie zwischen Generator und Außenwand andererseits vorteilhaft ist. Hierdurch vereinfacht sich die Herstellung des mit dem Generator ausgestatteten Bauteils, da die Montage vor der Querschnittsreduzierung der Außenwand in einem ungespannten Zustand realisierbar ist, so dass es beispielsweise einfach möglich ist, den thermoelektrischen Generator außen an der Außenwand anzubringen bzw. in die Außenwand einzuführen.

Weitere wichtige Merkmale und Vorteile der Erfindung ergeben sich aus den Unteransprüchen, aus den Zeichnungen und aus der zugehörigen Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in den Zeichnungen dargestellt und werden in der nachfolgenden Beschreibung näher erläutert, wobei sich gleiche Bezugszeichen auf gleiche oder ähnliche oder funktional gleiche Bauteile beziehen.

Es zeigen, jeweils schematisch
- Fig. 1: eine stark vereinfachte, schaltplanartige Prinzipdarstellung einer Abgasanlage,
- Fig. 2: einen Querschnitt der Abgasanlage im Bereich eines thermoelektrischen Generators,
- Fig. 3: eine vergrößerte Ansicht eines Details III aus Fig. 2, jedoch in einer ebenen Darstellung,
- Fig. 4 und 5: jeweils eine Draufsicht auf eine Federstruktur, bei verschiedenen Ausführungsformen,
- Fig. 6: eine isometrische Darstellung eines thermoelektrischen Generators mit zwei Generatormodulen.

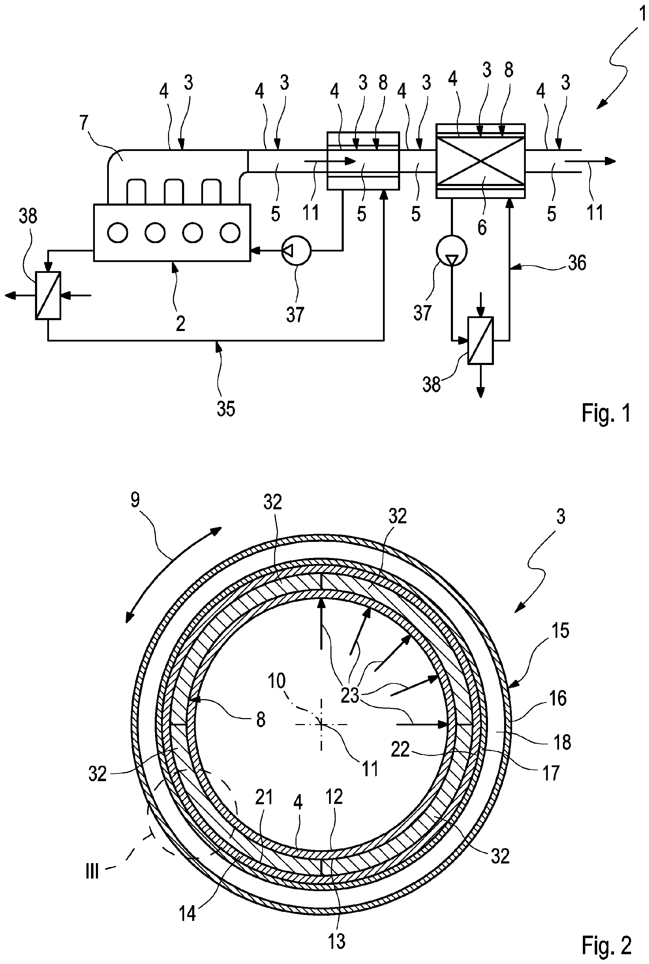

Entsprechend Figur 1 umfasst eine Abgasanlage 1, mit deren Hilfe Abgase einer Brennkraftmaschine 2 abgeführt werden, mehrere abgasführende Bauteile 3, die jeweils eine Innenwand 4 aufweisen. Die Brennkraftmaschine 2 und die Abgasanlage 1 können vorzugsweise in einem Straßenfahrzeug angeordnet sein. Ebenso sind auch andere mobile oder stationäre Anwendungen möglich, wie z.B. Off-Road-Fahrzeuge, mobile oder stationäre Baumaschinen und Arbeitsmaschinen. Bei den Bauteilen 3 handelt es sich im einfachsten Fall um ein Rohr 5 oder aber um eine Abgasbehandlungseinrichtung 6. Ebenso kann ein derartiges Bauteil 3 durch einen Abgassammler 7 bzw. Abgaskrümmer 7 gebildet sein. Im Beispiel der Figur 1 ist nur eine einzige Abgasbehandlungseinrichtung 6 gezeigt. Es ist klar, dass die Abgasanlage 1 gleichzeitig mehrere Abgasbehandlungseinrichtungen 6 aufweisen kann. Dabei kommen unterschiedliche Abgasbehandlungseinrichtungen 6 in Frage, wie zum Beispiel ein Oxidationskatalysator, ein Partikelfilter, ein SCR-Katalysator sowie ein NOX-Speicherkatalysator. Auch kann zumindest eine Abgasbehandlungseinrichtung 6 in Form eines Schalldämpfers vorgesehen sein. Grundsätzlich sind auch beliebige Kombinationen derartiger Abgasbehandlungseinrichtungen 6 vorstellbar.

Je nach Bauteil 3 ist die Innenwand 4 durch das Bauteil 3 selbst gebildet, z.B. wenn es sich dabei um ein Rohr 5 handelt, oder die Innenwand 4 ist durch einen Gehäuseabschnitt des Bauteils 3 gebildet, wenn es sich z.B. um eine Abgasbehandlungseinrichtung 6 oder um eine andere Komponente der Abgasanlage 1, wie zum Beispiel den Krümmer 7 handelt.

Entsprechend Figur 1 kann die Abgasanlage 1 außerdem mit wenigstens einem thermoelektrischen Generator 8 ausgestattet sein, der im Folgenden auch verkürzt als TE-Generator 8 oder als Generator 8 bezeichnet wird. Im Beispiel der Figur 1 sind rein exemplarisch zwei derartige TE-Generatoren 8 dargestellt. Der eine TE-Generator 8 ist an einem als Rohr 5 ausgestalteten Bauteil 3 angebracht, während der andere TE-Generator 8 an einem als Abgasbehandlungseinrichtung 6 ausgestalteten Bauteil 3 angebracht ist. Es ist klar, dass bei einer anderen Ausführungsform auch nur ein einziger TE-Generator 8 zum Einsatz kommen kann. Ebenso sind Ausführungsformen denkbar, bei denen mehr als zwei TE-Generatoren 8 verwendet werden können.

Der jeweilige TE-Generator 8 kann Wärme in elektrische Energie wandeln. Hierzu arbeitet der jeweilige TE-Generator 8 nach dem umgekehrten Peltier-Prinzip, indem er aus einem Wärmefluss eine elektrische Spannung erzeugt, die abgegriffen werden kann, um die gewünschte elektrische Energie bereitzustellen.

Entsprechend Figur 2, die einen Querschnitt eines mit einem TE-Generator 8 ausgestatteten Bauteils 3 der Abgasanlage 1 zeigt, ist die Innenwand 4 in einer Umfangsrichtung 9 ringförmig geschlossen. Die Umfangsrichtung 9 bezieht sich dabei auf eine Strömungsrichtung oder Hauptströmungsrichtung des Abgases, die bei einem geradlinigen Verlauf der Innenwand 4 mit einer Längsmittelachse 10 des Bauteils 3 bzw. der Innenwand 4 zusammenfällt. Im Querschnitt der Figur 2 steht die Längsmittelachse 10 senkrecht auf der Zeichnungsebene. Ebenso verlaufen die Strömungsrichtung und die Hauptströmungsrichtung dementsprechend senkrecht zur Zeichnungsebene der Figur 2. Diese Strömungsrichtung bzw. Hauptströmungsrichtung ist in Figur 1 durch Pfeile 11 symbolisiert.

Die Innenwand 4 des Bauteils 3 besitzt eine Innenseite 12, die dem Abgas bzw. der Abgasströmung ausgesetzt ist. Der thermoelektrische Generator 8 ist nun an einer Außenseite 13 der Innenwand 4 angeordnet, also durch die Innenwand 4 vom Abgas getrennt. Entsprechend der in Figur 2 gezeigten, bevorzugten Ausführungsform ist der TE-Generator 8 so ausgestaltet, dass er die Innenwand 4 des Bauteils 3 in der Umfangsrichtung 9 ringförmig geschlossen umfasst. Bei einer anderen, nicht gezeigten Ausführungsform kann der TE-Generator 8 die Innenwand 4 auch nur teilweise umfassen.

Die Begriffe "innen" und "außen", z.B. in Innenwand, Außenwand, Innenseite und Außenseite, beziehen sich auf die Relation zur Längsmittelachse 10, wobei "innen" der Längsmittelachse 10 zugewandt ist, während "außen" von der Längsmittelachse 10 abgewandt ist.

Das Bauteil 3 kann zusätzlich mit einer Außenwand 14 ausgestattet sein, welche die Innenwand 4 in der Umfangsrichtung 9 ringförmig geschlossen umfasst. Zweckmäßig ist dann der TE-Generator 8 zwischen der Innenwand 4 und der Außenwand 14 angeordnet. Im Beispiel der Figur 2 ist das Bauteil 3 außerdem mit einem Kühlmantel 15 ausgestattet, der die Innenwand 4 des Bauteils 3 in der Umfangsrichtung 9 ringförmig geschlossen umfasst. Der TE-Generator 8 ist dementsprechend zwischen der Innenwand 4 und dem Kühlmantel 15 angeordnet. Im Beispiel der Figur 2 ist die Außenwand 14 bezüglich des Kühlmantels 15 ein separates Bauteil und ist daher zusätzlich zum Kühlmantel 15 vorhanden. Dementsprechend befindet sich die Außenwand 14 ebenfalls zwischen dem Kühlmantel 15 und der Innenwand 4 bzw. zwischen dem Kühlmantel 15 und dem TE-Generator 8. Der Kühlmantel 15 besitzt im Beispiel der Figur 2 eine Außenwand 16 und eine Innenwand 17 und dazwischen einen Kühlmittelkanal 18, in dem ein geeignetes Kühlmittel zirkuliert. Der Kühlmittelkanal 18 kann beispielsweise ein ringförmiges Querschnittsprofil aufweisen, das sich koaxial zur Innenwand 4 erstreckt. Ebenso ist es möglich, den Kühlmantel 15 durch ein Rohr zu bilden, das bezüglich der Längsachse 10 schraubenförmig um den TE-Generator 8 bzw. um die Außenwand 14 gewickelt ist.

Der Kühlmantel 15 ist zusätzlich oder alternativ zur Außenwand 14 vorgesehen.

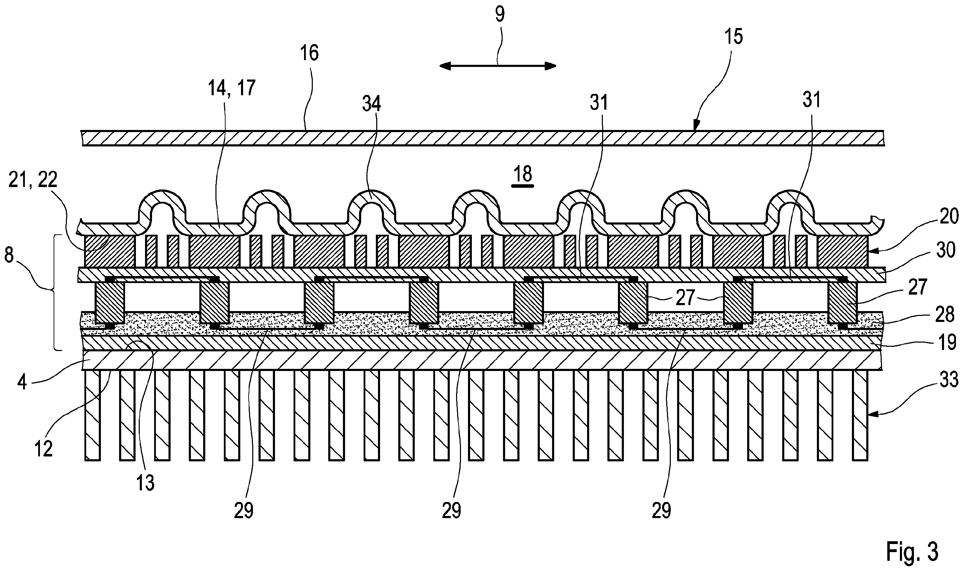

Bei der in Figur 2 gezeigten Ausführungsform liegt die Außenwand 14 des Bauteils 3 an der Innenwand 17 des Kühlmantels 15 an. Hierbei wird eine flächige Anlage bevorzugt, um einen möglichst günstigen Wärmetransport zu ermöglichen. Im Unterschied dazu zeigt Figur 3 eine Ausführungsform, bei welcher die Außenwand 14 des Bauteils 3 fehlt oder mit der Innenwand 17 des Kühlmantels 15 zusammenfällt bzw. durch die Innenwand 17 des Kühlmantels 15 gebildet ist. Bei dieser Bauweise fehlen zwei Wärmeübergänge, nämlich der Wärmeübergang vom TE-Generator 8 auf die Außenwand 14 und von der Außenwand 14 auf die Innenwand 17. Dementsprechend kann bei der in Figur 3 gezeigten Ausführungsform die Wärme effektiver abgeleitet werden.

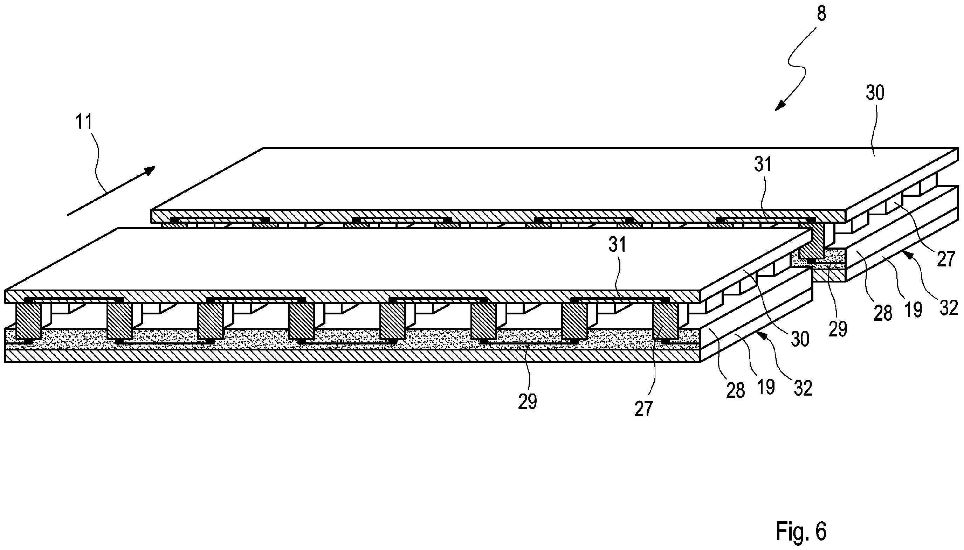

Der TE-Generator 8 liegt an der Außenseite 13 der Innenwand 4 des Bauteils 3 unmittelbar an, was einen intensiven Wärmeübergang von der Innenwand 4 auf den TE-Generator 8 ermöglicht. Dabei kann der TE-Generator 8 entsprechend den Figuren 3 und 6 eine innere Kontaktschicht 19 aufweisen, mit welcher der TE-Generator 8 an der Außenseite 13 der Innenwand 4 direkt zur Anlage kommt.

In den Figuren 3 und 6 ist der jeweils dargestellte Bereich des TE-Generators 8 eben bzw. abgerollt wiedergegeben, obwohl er im montierten Zustand der Figur 2 zweckmäßig gekrümmt ist. Dementsprechend erstreckt sich die Umfangsrichtung 9 in den Figuren 3 und 6 geradlinig. Es sind jedoch auch geradlinige oder ebene Abschnitte des TE-Generators 8 denkbar, da die Innenwand 4 nicht zwangsläufig einen kreisförmigen Querschnitt besitzen muss, sondern einerseits beliebige runde bzw. gekrümmte Querschnitte aufweisen kann und andererseits auch eckige, insbesondere rechteckige, Querschnitte besitzen kann.

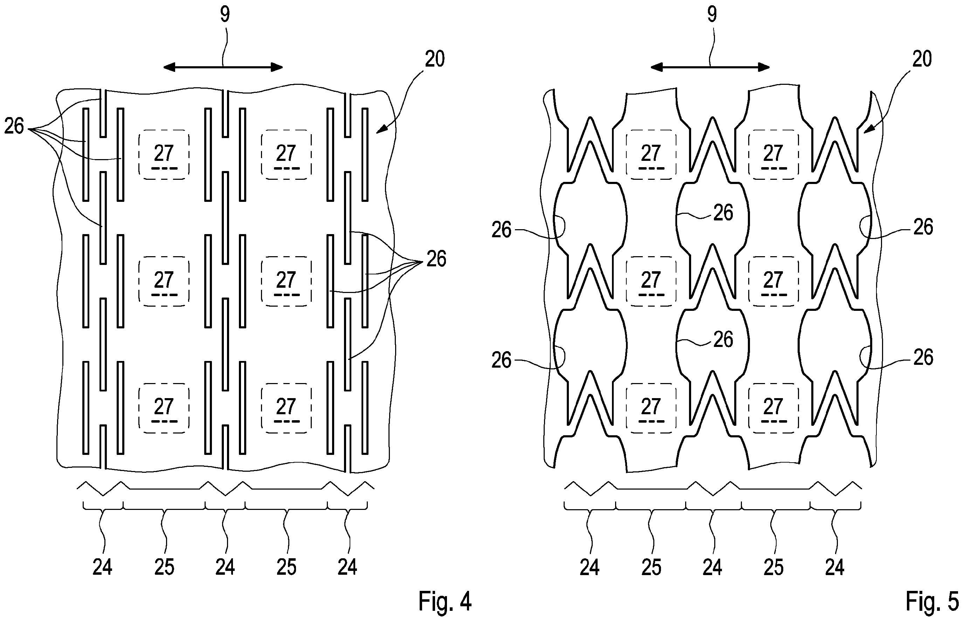

Entsprechend den Figuren 3 und 6 weist der TE-Generator 8 an einer der Außenwand 14 bzw. dem Kühlmantel 15 zugewandten Seite eine Federstruktur 20 auf, die in den Figuren 4 und 5 in einer Draufsicht, die bezüglich der Längsachse 10 radial orientiert ist, jeweils in einem Ausschnitt wiedergegeben ist. Die Federstruktur 20 führt dazu, dass der TE-Generator 8 an einer Innenseite 21 der Außenwand 14 des Bauteils 3 oder an einer Innenseite 22 der Innenwand 17 des Kühlmantels 15 vorgespannt abgestützt ist. Die Vorspannung ist dabei bezogen auf die Axialrichtung 10 bzw. auf die Strömungsrichtung 11 radial orientiert. Eine radial vorgespannte Kontaktierung des TE-Generators 8 einerseits an der Innenwand 4 und andererseits an der Außenwand 14 bzw. am Kühlmantel 15 verbessert die Wärmeübertragung von der Innenwand 4 über den TE-Generator 8 zur Außenwand 14 bzw. zum Kühlmantel 15. Je besser diese Wärmeleitung ist, desto besser ist die mit dem TE-Generator 8 erzielbare Ausbeute an elektrischer Energie.

Die Federstruktur 20 erlaubt jedoch auch eine radiale Relativbewegung zwischen der Innenwand 4 und dem Kühlmantel 15, die zwangsläufig auch zu einer Bewegung des TE-Generators 8 relativ zum Kühlmantel 15 führt. In Figur 2 sind mehrere Pfeile 23 wiedergegeben, welche die Ausdehnung der Innenwand 4 im Falle einer Aufheizung der Innenwand 4 bei einem Kaltstart der Brennkraftmaschine 2 andeuten. Bei einem solchen Kaltstart wärmt sich die Innenwand 4 zeitlich vor der Außenwand 14 bzw. gegenüber dem ohnehin gekühlten Kühlmantel 15 auf. Insoweit kommt es zu einer solchen Ausdehnung, die zu einer Relativverstellung des TE-Generators 8 gegenüber der Außenwand 14 bzw. gegenüber dem Kühlmantel 15 führt. Die Federstruktur 20 erlaubt eine derartige Relativverstellung und bewirkt dabei gleichzeitig eine zunehmende Vorspannung des TE-Generators 8 einerseits gegen die Innenwand 4 und andererseits gegen die Außenwand 14 bzw. gegen den Kühlmantel 15. Hierdurch verbessert sich im Betrieb der Brennkraftmaschine 2 die Effizienz des TE-Generators 8.

Die Federstruktur 20 ist gemäß den Figuren 4 und 5 in der Umfangsrichtung 9 federelastisch nachgiebig ausgestaltet, so dass die Federstruktur 20 ohne weiteres die Ausdehnung bzw. die Verstellung des TE-Generators 8 nach außen kompensieren kann. Zur Realisierung der erwünschten Federelastizität innerhalb der Federstruktur 20 kann die Federstruktur 20 Bereiche 24 und 25 aufweisen, die in der Umfangsrichtung 9 unterschiedliche Elastizitäten besitzen. Dabei wechseln sich in der Umfangsrichtung 9 Bereiche 24 höherer Elastizität und Bereiche 25 niedrigerer Elastizität ab. Die Bereiche höherer Elastizität 24 sind in den Beispielen der Figuren 4 und 5 jeweils mit Hilfe von Durchbrüchen 26 realisiert, die in Form von Schlitzen (Figur 4) oder mit komplexen Geometrien (Figur 5) realisiert sein können, um die gewünschte Federelastizität zu gewährleisten. Ebenso ist es möglich, anstelle von Durchbrüchen 26 die Dicke des Federmaterials zu reduzieren, um auf diese Weise die Federelastizität zu erhöhen. Auch ist eine dreidimensionale Formgebung gezielt so durchführbar, dass die Federstruktur 20 in den Bereichen 24 eine höhere Federelastizität in der Umfangsrichtung 9 aufweist als in den Bereichen 25. Beispielsweise können die Bereiche 24 wellenförmig gestaltet oder zick-zack-förmig gefaltet sein, wobei sich die einzelnen Wellen oder Falten parallel zur Längsachse 10 erstrecken und in der Umfangsrichtung 10 benachbart sind. Ebenso ist es möglich, die Bereiche 25 mit niedrigerer Elastizität durch Sicken oder dergleichen auszusteifen. Die Federstruktur 20 kann insbesondere als Blechformteil konzipiert sein.

Entsprechend den Figuren 3 und 6 weist der TE-Generator 8 zweckmäßig eine Vielzahl einzelner thermoelektrischer Elemente 27 auf, die im Folgenden auch als TE-Elemente 27 oder Elemente 27 bezeichnet werden können. Die einzelnen TE-Elemente 27 können jeweils Wärme in elektrische Energie wandeln. Zur Bildung des TE-Generators 8 sind die TE-Elemente 27 elektrisch miteinander verschaltet und gemäß Figur 3 zumindest in der Umfangsrichtung 9 voneinander beabstandet. Gemäß Figur 6 können die TE-Elemente 27 auch in der Axialrichtung 10 voneinander beabstandet sein. Es ist klar, dass dann Reihen von TE-Elementen 27, die in der Umfangsrichtung 9 benachbarte TE-Elemente 27 aufweisen, in der Axialrichtung 10 zueinander benachbart sind.

Zweckmäßig ist nun eine Ausführungsform, bei welcher die Federstruktur 20 hinsichtlich ihrer Bereiche 24, 25 auf die Positionierung der TE-Elemente 27 innerhalb des TE-Generators 8 abgestimmt ist, und zwar gezielt so, dass die TE-Elemente 27 an der Federstruktur 20 jeweils in den Bereichen 25 positioniert sind, welche die niedrigere Elastizität besitzen. Hierdurch wird die radiale Vorspannung gezielt an den Positionen der TE-Elemente 27 eingeleitet.

Wie den Figuren 3 und 6 zu entnehmen ist, kann der TE-Generator 8 zumindest eine Trägermatrix 28 aufweisen, an der die zugehörigen TE-Elemente 27 zueinander lagefixiert angeordnet sind. Erkennbar sind die einzelnen TE-Elemente 27 dazu teilweise in die Trägermatrix 28 eingebettet. Besonders vorteilhaft ist dabei eine Ausführungsform, bei welcher die Trägermatrix 28 elektrische Kontakte 29 enthält, welche die TE-Elemente 27 auf geeignete Weise elektrisch miteinander verbinden. Die Kontakte 29 können hierzu in die Trägermatrix 28 eingebettet sein, also innerhalb der Trägermatrix 28 verlaufen.

Der TE-Generator 8 kann außerdem mit einer äußeren Kontaktschicht 30 ausgestattet sein, über die sich der TE-Generator 8 an der Federstruktur 20 abstützt. Im Beispiel ist auch die äußere Kontaktschicht 30 mit elektrischen Kontakten 31 ausgestattet, welche die TE-Elemente 27 auf geeignete Weise miteinander elektrisch verbinden. Auch diese Kontakte 31 können zweckmäßig in die äußere Kontaktschicht 30 eingebettet sein, so dass diese innerhalb der äußeren Kontaktschicht 30 verlaufen. In den gezeigten Beispielen sind die einzelnen TE-Elemente 27 in Reihe geschaltet, so dass benachbarte TE-Elemente 27 wechselweise durch die Kontakte 29 der Trägermatrix 28 und durch die Kontakte 31 der äußeren Kontaktschicht 30 miteinander elektrisch verbunden sind.

Die innere Kontaktschicht 19 und/oder die äußere Kontaktschicht 30 dient zur Verbesserung bzw. zur Erzielung eines flächigen Kontakts mit der Innenwand 4 bzw. mit der Außenwand 14 bzw. mit dem Kühlmantel 15. Die jeweilige Kontaktschicht 19 bzw. 30 kann dabei insbesondere einen Toleranzausgleich realisieren. Als Kontaktschicht 19, 30 eignet sich beispielsweise eine Graphitfolie.

Die innere Kontaktschicht 19 und/oder die äußere Kontaktschicht 30 kann/können unabhängig von den hier gezeigten Ausführungsformen einen mehrschichtigen oder mehrlagigen Aufbau aufweisen. Beispielsweise können druckfeste Isolationsfolien, z.B. aus Polyimid, Aramid, Kapton oder allgemein aus Duroplasten bzw. aus temperaturbeständigen Kunststoffen, zur Einbettung und Isolation der Leiter 29, 31 und zur Isolation gegenüber der Innenwand 4 bzw. gegenüber der Außenwand 14 bzw. dem Kühlmantel 15 vorgesehen sein.

Entsprechend den Figuren 2 und 6 kann der TE-Generator 8 entsprechend einer bevorzugten Ausführungsform modular aufgebaut sein. Dementsprechend umfasst der jeweilige TE-Generator 8 mehrere Generatormodule 32. Diese Generatormodule 32 sind auf geeignete Weise elektrisch miteinander verschaltet, um im zusammengebauten Zustand den TE-Generator 8 zu bilden. Entsprechend Figur 2 können mehrere Generatormodule 32 in der Umfangsrichtung 9 benachbart angeordnet sein. Figur 2 zeigt exemplarisch vier gleiche Generatormodule 32, die jeweils ein Bogensegment von 90° abdecken. Es ist klar, dass auch andere Teilungen realisierbar sind. Im Unterschied dazu zeigt Figur 6 zwei Generatormodule 32, die in der Hauptströmungsrichtung 11, die innerhalb des jeweiligen Bauteils 3 zumindest innerhalb der Innenwand 4 vorherrscht, hintereinander angeordnet sind.

Erkennbar besitzt jedes Generatormodul 32 mehrere TE-Elemente 27, die Trägermatrix 28 und optional die Kontaktschichten 19, 30. Zweckmäßig werden identische Generatormodule 32 bereitgestellt, die an die jeweilige Anwendungsform, also an das jeweilige Bauteil 3 angepasst werden können.

Die Innenwand 17 des Kühlmantels 15 kann gemäß Fig. 3 eine in Axialrichtung und/oder in Umfangsrichtung federelastische Struktur (34) aufweisen, die insbesondere wellenförmig gestaltet sein kann.

Bei der in Figur 3 gezeigten, besonderen Ausführungsform ist außerdem erkennbar, dass die Innenwand 4 an ihrer Innenseite 12 mit einer Wärmetauscherstruktur 33 ausgestattet sein kann. Eine derartige Wärmetauscherstruktur 33, die beispielsweise eine Vielzahl von Rippen oder Lamellen oder dergleichen aufweisen kann, verbessert die Wärmeübertragung des Abgases auf die Innenwand 4. Zusätzlich oder alternativ kann die Innenwand 17 des Kühlmantels 15 ebenfalls eine Wärmetauscherstruktur 34 aufweisen, die beispielsweise durch Rippen oder Sicken oder eine Wellenform realisiert sein kann. Auch diese Wärmetauscherstruktur 34 verbessert den Wärmeübergang, und zwar von der Innenwand 17 auf das im Kühlmittelkanal 18 transportierte Kühlmittel. Es ist klar, dass zusätzlich oder alternativ auch die Außenseite 16 des Kühlmantels 15 mit einer derartigen Wärmetauscherstruktur 34 ausgestattet sein kann. Ferner ist klar, dass die Wärmetauscherstruktur 33 der Innenwand 4 und/oder die Wärmetauscherstruktur 34 des Kühlmantels 15 unabhängig voneinander realisiert werden können und auch unabhängig von den anderen in Figur 3 gezeigten Merkmalen des TE-Generators 8 bzw. des speziellen Ausführungsbeispiels der Figur 3 realisiert sein können.

Entsprechend Figur 1 kann der Kühlmantel 15 an einen Kühlkreis 35 bzw. 36 angeschlossen sein. Im Beispiel sind zur vereinfachten Erläuterung zwei Kühlkreise 35, 36 dargestellt, nämlich ein Hochtemperatur-Kühlkreis 35, bei dem es sich beispielsweise um den Kühlkreis der Brennkraftmaschine 2 handeln kann, sowie ein Niedertemperatur-Kühlkreis 36, der sich gegenüber dem Hochtemperatur-Kühlkreis 35 durch eine deutlich niedrigere Temperatur im Kühlmittel auszeichnet. Beispielsweise kann im Niedertemperatur-Kühlkreis 36 eine Kühlmitteltemperatur von etwa 20° realisiert werden. Im Unterschied dazu hat der Hochtemperatur-Kühlmittelkreis 35 üblicherweise eine Kühlmitteltemperatur von etwa 90°. Eine besonders hohe Effizienz des TE-Generators 8 kann in Verbindung mit einem besonders hohen Temperaturgefälle realisiert werden. Ein besonders hohes Temperaturgefälle kann mit Hilfe des Niedertemperatur-Kühlkreises 36 realisiert werden. Der jeweilige Kühlkreis 35, 36 enthält eine Kühlmittelpumpe 37 sowie einen geeigneten Wärmetauscher 38, der beispielsweise mit Umgebungsluft beaufschlagt sein kann. Die in Figur 1 gezeigte Positionierung der einzelnen Komponenten des jeweiligen Kühlkreises 35, 36 ist dabei rein exemplarisch. Insbesondere ist die gezeigte Positionierung des Kühlmantels 15 im Hochtemperatur-Kühlkreis 35 stromauf der Brennkraftmaschine 2 suboptimal.

Für die Herstellung des Bauteils 3 kann vorgesehen sein, zunächst eine Anordnung zu schaffen, bei welcher der thermoelektrische Generator 8 radial zwischen der Innenwand 4 und der Außenwand 14 angeordnet ist. Dies kann beispielsweise dadurch realisiert werden, dass zunächst der thermoelektrische Generator 8 außen an der Innenwand 4 angebracht wird. Anschließend kann die Außenwand 14 axial auf die Einheit aus Innenwand 4 und Generator 8 aufgeschoben werden. Ebenso ist es möglich, zunächst den thermoelektrischen Generator 8 in die Außenwand 14 einzuführen, um anschließend die Innenwand 4 in die Einheit aus Generator 8 und Außenwand 14 axial einzuführen.

Anschließend wird die Außenwand 14 plastisch umgeformt, derart, dass sich ihr Querschnitt reduziert. Die Umformung erfolgt daher in radialer Richtung. Ziel dieses Umformvorgangs ist die Erzeugung einer elastischen Komprimierung des thermoelektrischen Generators 8 bzw. der Federstruktur 20 des Generators 8. Hierdurch kann durch die Umformung der Außenwand 14 die gewünschte radiale Vorspannung des Generators 8 gegenüber der Innenwand 4 sowie gegenüber der Außenwand 14 hergestellt werden. Diese nachträgliche Erzeugung der inneren radialen Vorspannung ist von Vorteil, da dadurch das Einbringen des Generators 8 in den Ringraum radial zwischen der Innenwand 4 und der Außenwand 14 während des Zusammenbaus erheblich vereinfacht ist.

## Patentansprüche

1. Abgasanlage für eine Brennkraftmaschine (2), insbesondere eines Straßenfahrzeugs oder einer anderen mobilen oder stationären Einrichtung,
- mit mindestens einem abgasführenden Bauteil (3), das eine in Umfangsrichtung (9) ringförmig geschlossene Innenwand (4) aufweist, deren Innenseite (12) dem Abgas ausgesetzt ist, und
- mit mindestens einem thermoelektrischen Generator (8), der Wärme in elektrische Energie wandelt und der an einer Außenseite (13) der Innenwand (4) des Bauteils (3) angeordnet ist,
- wobei der thermoelektrische Generator (8) an einer der Innenwand (4) des Bauteils (3) zugewandten Innenseite (21) einer diese Innenwand (4) in Umfangsrichtung (9) ringförmig geschlossen umfassenden Außenwand (14) des Bauteils (3) oder an einer der Innenwand (4) des Bauteils (3) zugewandten Innenseite (22) einer Innenwand (17) eines die Innenwand (4) des Bauteils (3) in Umfangsrichtung (9) ringförmig geschlossen umfassenden Kühlmantels (15) über eine Federstruktur (20) unter Vorspannung abgestützt ist,
**dadurch gekennzeichnet,**
- **dass** die Federstruktur (20) Bereiche (24, 25) mit unterschiedlicher Elastizität in Umfangsrichtung (9) aufweist, wobei sich Bereiche (24) höherer Elastizität und Bereiche (25) niedrigerer Elastizität in Umfangsrichtung (9) abwechseln, und
- **dass** der thermoelektrische Generator (8) eine Vielzahl einzelner thermoelektrischer Elemente (27) aufweist, die jeweils Wärme in elektrische Energie wandeln, und die elektrisch miteinander verschaltet sind und in Umfangsrichtung (9) voneinander beabstandet sind.

2. Abgasanlage nach Anspruch 1,
**dadurch gekennzeichnet,**
**dass** der thermoelektrische Generator (8) die Innenwand (4) in Umfangsrichtung (9) ringförmig geschlossen umfasst.

3. Abgasanlage nach Anspruch 1 oder 2,
**dadurch gekennzeichnet,**
**dass** die Außenwand (14) des Bauteils (3) durch eine Innenwand (17) des Kühlmantels (15) gebildet ist.

4. Abgasanlage nach Anspruch 1 oder 2,
**dadurch gekennzeichnet,**
**dass** die Außenwand (14) des Bauteils (3) an einer Innenwand (17) des Kühlmantels (15) anliegt.

5. Abgasanlage nach einem der Ansprüche 1 bis 4,
**dadurch gekennzeichnet,**
**dass** der thermoelektrische Generator (8) an der Außenseite (13) der Innenwand (4) des Bauteils (3) anliegt.

6. Abgasanlage nach einem der Ansprüche 1 bis 5,
**dadurch gekennzeichnet,**
**dass** die Federstruktur (20) in der Umfangsrichtung (9) federelastisch nachgiebig ausgestaltet ist.

7. Abgasanlage nach einem der Ansprüche 1 bis 6,
**dadurch gekennzeichnet,**
**dass** die thermoelektrischen Elemente (27) an der Federstruktur (20) in den Bereichen (25) niedrigerer Elastizität positioniert sind.

8. Abgasanlage nach einem der Ansprüche 1 bis 7,
**dadurch gekennzeichnet,**
**dass** der thermoelektrische Generator (8) zumindest eine Trägermatrix (28) aufweist, an der mehrere thermoelektrische Elemente (27) zueinander lagefixiert angeordnet sind.

9. Abgasanlage nach Anspruch 8,
**dadurch gekennzeichnet,**
**dass** die thermoelektrischen Elemente (27) durch innerhalb der Trägermatrix (28) verlaufende elektrische Kontakte (29) miteinander elektrisch verbunden sind.

10. Abgasanlage nach einem der Ansprüche 1 bis 9,
**dadurch gekennzeichnet,**
**dass** der thermoelektrische Generator (8) eine äußere Kontaktschicht (30) aufweist, mit welcher er an der Federstruktur (20) abgestützt ist.

11. Abgasanlage nach Anspruch 10,
**dadurch gekennzeichnet,**
**dass** die thermoelektrischen Elemente (27) durch innerhalb der äußeren Kontaktschicht (30) verlaufende elektrische Kontakte (31) miteinander elektrisch verbunden sind.

12. Abgasanlage nach einem der vorhergehenden Ansprüche,
**dadurch gekennzeichnet,**
**dass** der thermoelektrische Generator (8) eine innere Kontaktschicht (19) aufweist, mit welcher er an der Außenseite (13) der Innenwand (4) anliegt.

13. Abgasanlage nach einem der Ansprüche 1 bis 12,
**dadurch gekennzeichnet,**
**dass** der thermoelektrische Generator (8) modular aufgebaut ist, wobei mehrere Generatormodule (32) in Umfangsrichtung (9) und/oder in der Hauptströmungsrichtung (11) des Abgases innerhalb des Bauteils (3) benachbart angeordnet sind.

14. Abgasanlage nach Anspruch 13,
**dadurch gekennzeichnet,**
- **dass** jedes Generatormodul (32) mehrere thermoelektrische Elemente (27) aufweist, und/oder
- **dass** jedes Generatormodul (32) eine Trägermatrix (28) und/oder eine äußere Kontaktschicht (30) und/oder eine innere Kontaktschicht (19) aufweist.

15. Verfahren zum Herstellen einer Abgasanlage (1) nach einem der vorhergehenden Ansprüche,
- wobei die Abgasanlage (1) mindestens ein abgasführendes Bauteil (3) aufweist, das eine in Umfangsrichtung (9) ringförmig geschlossene Innenwand (4) aufweist, deren Innenseite (12) dem Abgas ausgesetzt ist,
- wobei die Abgasanlage (1) mindestens einen thermoelektrischen Generator (8) aufweist, der Wärme in elektrische Energie wandelt und der an einer Außenseite (13) der Innenwand (4) des Bauteils (3) angeordnet ist,
- wobei der thermoelektrische Generator (8) die Innenwand (4) des Bauteils (3) in Umfangsrichtung (9) ringförmig geschlossen umfasst,
- wobei eine Außenwand (14) des Bauteils (3) die Innenwand (4) des Bauteils (3) in Umfangsrichtung (9) ringförmig geschlossen umfasst, wobei der thermoelektrische Generator (8) zwischen der Innenwand (4) und der Außenwand (14) angeordnet ist,
- bei dem der zwischen der Innenwand (4) und der Außenwand (14) angeordnete thermoelektrische Generator (8) durch eine Federstruktur (20) radial vorgespannt wird, und
- bei dem die Außenwand (14) zur Reduzierung ihres Querschnitts plastisch umgeformt wird,
**dadurch gekennzeichnet,**
- **dass** die Federstruktur (20) Bereiche (24, 25) mit unterschiedlicher Elastizität in Umfangsrichtung (9) aufweist, wobei sich Bereiche (24) höherer Elastizität und Bereiche (25) niedrigerer Elastizität in Umfangsrichtung (9) abwechseln, und
- **dass** der thermoelektrische Generator (8) eine Vielzahl einzelner thermoelektrischer Elemente (27) aufweist, die jeweils Wärme in elektrische Energie wandeln, und die elektrisch miteinander verschaltet sind und in Umfangsrichtung (9) voneinander beabstandet sind.

## Claims

1. An exhaust system for a combustion engine (2), more preferably of a road vehicle or another mobile or stationary device,
- with at least one exhaust gas-conducting component (3) having an inner wall (4) closed ring-like in circumferential direction (9), whose inner side (12) is exposed to the exhaust gas, and
- with at least one thermoelectric generator (8) which converts heat into electric energy and which is arranged on an outer side (13) of the inner wall (4) of the component (3),
- wherein the thermoelectric generator (8) is supported via a spring structure (20) under preload on an inner side (21) of an outer wall (14) of the component (3), said inner side (21) facing the inner wall (4) of the component (3) and said outer wall (14) of the component (3) surrounding the inner wall (4) ring-shaped in circumferential direction (9) in a closed manner, or on an inner side (22) of an inner wall (17) of a cooling jacket (15), said inner side (22) facing the inner wall (4) of the component (3) and said cooling jacket (15) surrounding the inner wall (4) of the component (3) ring-shaped in circumferential direction (9) in a closed manner,
**characterized in**
- **that** the spring structure (20) comprises regions (24, 25) with different elasticity in circumferential direction (9), wherein regions (24) of higher elasticity and regions (25) of lower elasticity alternate in circumferential direction (9), and
- **that** the thermoelectric generator (8) comprises a multiplicity of individual thermoelectric elements (27) which convert heat into electric energy and which are electrically interconnected and spaced from one another in circumferential direction (9).

2. The exhaust system according to Claim 1,
**characterized in**
**that** the thermoelectric generator (8) surrounds the inner wall ring-shaped in circumferential direction (9) in a closed manner.

3. The exhaust system according to Claim 1 or 2,
**characterized in**
**that** the outer wall (14) of the component (3) is formed through an inner wall (17) of the cooling jacket (15).

4. The exhaust system according to Claim 1 or 2,
**characterized in**
**that** the outer wall (14) of the component (3) contacts an inner wall (17) of the cooling jacket (15).

5. The exhaust system according to any one of the Claims 1 to 4, **characterized in,**
**that** the thermoelectric generator (8) contacts the outer side (13) of the inner wall (4) of the component (3).

6. The exhaust system according to any one of Claims 1 to 5,
**characterized in**
**that** the spring structure (20) in circumferential direction (9) is configured yielding spring-elastically.

7. The exhaust system according to any one of Claims 1 to 6,
**characterized in that**
the thermoelectric elements (27) are positioned on the spring structure (20) in the regions (25) of lower elasticity.

8. The exhaust system according to any one of Claims 1 to 7,
**characterized in**
**that** the thermoelectric generator (8) comprises at least one substrate matrix (28) on which a plurality of thermoelectric elements (27) fixed in position relative to one another is arranged.

9. The exhaust system according to Claim 8,
**characterized in**
**that** the thermoelectric elements (27) are electrically interconnected through contacts (29) running within the substrate matrix (28).

10. The exhaust system according to any one of the Claims 1 to 9, **characterized in**
**that** the thermoelectric generator (8) comprises an outer contact layer (30) with which it is supported on the spring structure (20).

11. The exhaust system according to Claim 10,
**characterized in**
**that** the thermoelectric elements (27) are electrically interconnected through electrical contacts (31) running within the outer contact layer (30).

12. The exhaust system according to any one of the preceding Claims,
**characterized in**
**that** the thermoelectric generator (8) has an inner contact layer (19) with which it contacts the outer side (13) of the inner wall (4),

13. The exhaust system according to any one of the Claims 1 to 12,
**characterized in**
**that** the thermoelectric generator (8) is of a modular construction, wherein a plurality of generator modules (32) are arranged adjacently in circumferential direction (9) and/or in the main flow direction (11) of the exhaust gas within the component (3).

14. The exhaust system according to Claim 13,
**characterized in**
- **that** each generator module (32) comprises a plurality of thermoelectric elements (27), and/or
- **that** each generator module (32) comprises a substrate matrix (28) and/or an outer contact layer (30) and/or an inner contact layer (19).

15. A method for producing an exhaust system (1) according to any one of the preceding Claims,
- wherein the exhaust system (1) comprises at least one exhaust gas-conducting component (3) having an inner wall (4) closed ring-like in circumferential direction (9), whose inner side (12) is exposed to the exhaust gas,
- wherein the exhaust system (1) comprises at least one thermoelectric generator (8) which converts heat into electric energy and which is arranged on an outer side (13) of the inner wall (4) of the component (3),
- wherein the thermoelectric generator (8) surrounds the inner wall (4) of the component (3) ring-shaped in circumferential direction (9) in a closed manner,
- wherein an outer wall (14) of the component (3) surrounds the inner wall (4) of the component (3) ring-shaped in circumferential direction (9) in a closed manner, wherein the thermoelectric generator (8) is arranged between the inner wall (4) and the outer wall (14),
- in which the thermoelectric generator (8) arranged between the inner wall (4) and the outer wall (14) is radially preloaded by a spring structure (20), and
- in which the outer wall (14) for reducing its cross section is plastically re-formed. **characterized in**
- **that** the spring structure (20) comprises regions (24, 25) with different elasticity in circumferential direction (9), wherein regions (24) of higher elasticity and regions (25) of lower elasticity alternate in circumferential direction (9), and
- **that** the thermoelectric generator (8) comprises a multiplicity of individual thermoelectric elements (27) which convert heat into electric energy and which are electrically interconnected and spaced from one another in circumferential direction (9).

## Revendications

1. Système d'échappement pour un moteur à combustion interne (2), en particulier un véhicule routier ou un autre dispositif mobile ou fixe,
- avec au moins un composant (3) conduisant des gaz d'échappement qui présente une paroi intérieure (4) fermée en forme d'anneau dans une direction circonférentielle (9) dont le côté interne (12) est exposé aux gaz d'échappement, et
- avec au moins un générateur thermoélectrique (8), qui convertit la chaleur en énergie électrique et qui est agencé sur un côté extérieur (13) de la paroi intérieure (4) du composant (3),
- dans lequel le générateur thermoélectrique (8) est supporté sous précontrainte par l'intermédiaire d'une structure à ressort (20), au niveau d'un côté intérieur (21) faisant face à la paroi intérieure (4) du composant (3) d'une paroi extérieure (14) fermée en forme d'anneau dans une direction circonférentielle (9) du composant (3) comprenant cette paroi intérieure (4), ou au niveau d'un côté intérieur (22) faisant face à la paroi intérieure (4) du composant (3) d'une paroi intérieure (17) d'une enveloppe de refroidissement (15) fermée en forme d'anneau dans une direction circonférentielle (9) comprenant la paroi intérieure (4) du composant (3),
**caractérisé en ce que**
- la structure à ressort (20) présente des régions (24, 25) ayant une élasticité différente dans la direction circonférentielle (9), dans lequel des régions (24) d'élasticité supérieure et des régions (25) d'élasticité inférieure alternent dans la direction circonférentielle (9), et
- le générateur thermoélectrique (8) présente une pluralité d'éléments thermoélectriques individuels (27), qui convertissent chacun de la chaleur en énergie électrique, et qui sont connectés électriquement les uns aux autres et espacés les uns des autres dans la direction circonférentielle (9).

2. Système d'échappement selon la revendication 1,
**caractérisé en ce que**
le générateur thermoélectrique (8) comprend la paroi intérieure (4) fermée en forme d'anneau dans la direction circonférentielle (9).

3. Système d'échappement selon la revendication 1 ou 2,
**caractérisé en ce que**
la paroi extérieure (14) du composant (3) est formée par une paroi intérieure (17) de l'enveloppe de refroidissement (15).

4. Système d'échappement selon la revendication 1 ou 2,
**caractérisé en ce que**
la paroi extérieure (14) du composant (3) repose sur une paroi intérieure (17) de l'enveloppe de refroidissement (15).

5. Système d'échappement selon l'une quelconque des revendications 1 à 4,
**caractérisé en ce que**
le générateur thermoélectrique (8) repose sur le côté extérieur (13) de la paroi intérieure (4) du composant (3).

6. Système d'échappement selon l'une quelconque des revendications 1 à 5,
**caractérisé en ce que**
la structure à ressort (20) est conçue déformable de manière élastique dans la direction circonférentielle (9).

7. Système d'échappement selon l'une quelconque des revendications 1 à 6,
**caractérisé en ce que**
les éléments thermoélectriques (27) sont positionnés sur la structure à ressort (20) dans les régions (25) d'une élasticité inférieure.

8. Système d'échappement selon l'une quelconque des revendications 1 à 7,
**caractérisé en ce que**
le générateur thermoélectrique (8) présente au moins une matrice de support (28), sur laquelle sont agencés plusieurs éléments thermoélectriques (27) fixés en position les uns par rapport aux autres.

9. Système d'échappement selon la revendication 8,
**caractérisé en ce que**
les éléments thermoélectriques (27) sont connectés électriquement les uns aux autres par des contacts électriques (29) s'étendant à l'intérieur de la matrice de support (28).

10. Système d'échappement selon l'une quelconque des revendications 1 à 9,
**caractérisé en ce que**
le générateur thermoélectrique (8) présente une couche de contact extérieure (30), via laquelle il est supporté sur la structure à ressort (20).

11. Système d'échappement selon la revendication 10,
**caractérisé en ce que**
les éléments thermoélectriques (27) sont connectés électriquement les uns aux autres par des contacts électriques (31) s'étendant à l'intérieur de la couche de contact extérieure (30).

12. Système d'échappement selon l'une des revendications précédentes,
**caractérisé en ce que**
le générateur thermoélectrique (8) présente une couche de contact intérieure (19), via laquelle il repose contre le côté extérieur (13) de la paroi intérieure (4).

13. Système d'échappement selon l'une des revendications 1 à 12,
**caractérisé en ce que**
le générateur thermoélectrique (8) est de conception modulaire, dans lequel une pluralité de modules de générateur (32) sont agencés de manière proche dans la direction circonférentielle (9) et/ou dans la direction d'écoulement principal (11) des gaz d'échappement à l'intérieur du composant (3).

14. Système d'échappement selon la revendication 13,
**caractérisé en ce que**
- chaque module de générateur (32) présente une pluralité d'éléments thermoélectriques (27), et/ou
- chaque module générateur (32) présente une matrice de support (28) et/ou une couche de contact extérieure (30) et/ou une couche de contact intérieure (19).

15. Procédé de fabrication d'un système d'échappement (1) selon l'une des revendications précédentes,
- dans lequel le système d'échappement (1) présente au moins un composant (3) conducteur de gaz d'échappement qui présente une paroi intérieure (4) fermée en forme d'anneau dans la direction circonférentielle (9), dont le côté interne (12) est exposé aux gaz d'échappement,
- dans lequel le système d'échappement (1) présente au moins un générateur thermoélectrique (8), qui convertit de la chaleur en énergie électrique et qui est agencé sur un côté extérieur (13) de la paroi intérieure (4) du composant (3),
- dans lequel le générateur thermoélectrique (8) comprend la paroi intérieure (4) du composant (3) dans la direction circonférentielle (9) fermée en forme d'anneau,
- dans lequel une paroi extérieure (14) du composant (3) comprend la paroi intérieure (4) du composant (3) fermée en forme d'anneau dans la direction circonférentielle (9), dans lequel le générateur thermoélectrique (8) est agencé entre la paroi intérieure (4) et la paroi extérieure (14),
- dans lequel un générateur thermoélectrique (8) agencé entre la paroi intérieure (4) et la paroi extérieure (14) est précontraint de manière radiale par l'intermédiaire d'une structure à ressort (20), et
- dans lequel la paroi extérieure (14) se déforme plastiquement pour réduire sa section transversale,
**caractérisé en ce que**
- la structure à ressort (20) présente des régions (24, 25) d'une élasticité différente dans la direction circonférentielle (9), dans lequel des régions (24) d'une élasticité supérieure et des régions (25) d'une élasticité inférieure alternent dans la direction circonférentielle (9), et
- le générateur thermoélectrique (8) présente une pluralité d'éléments thermoélectriques (27) individuels, qui convertissent chacun de la chaleur en énergie électrique, et qui sont connectés électriquement les uns aux autres et espacés les uns des autres dans la direction circonférentielle (9).
